# EUROPÄISCHE PATENTSCHRIFT

(11) **EP 2 526 613 B1**
(45) Veröffentlichungstag und Bekanntmachung des Hinweises auf die Patenterteilung: **29.04.2020**
(21) Anmeldenummer: 10807330.5
(22) Anmeldetag: 30.12.2010
(51) Int. Cl.: H02M 1/44, H05K 1/02

(54) **ELEKTRONIKVORRICHTUNG UND HERSTELLUNGSVERFAHREN FÜR EINE ELEKTRONIKVORRICHTUNG**
ELECTRONICS APPARATUS AND PRODUCTION METHOD FOR AN ELECTRONICS APPARATUS
DISPOSITIF ÉLECTRONIQUE ET PROCÉDÉ DE FABRICATION D'UN DISPOSITIF ÉLECTRONIQUE

(30) Priorität: 22.01.2010 DE 102010001152
(43) Veröffentlichungstag der Anmeldung: 28.11.2012
(73) Patentinhaber: Robert Bosch GmbH, 70442 Stuttgart (DE)
(72) Erfinder: SPARKA, Hartmut, 71701 Schwieberdingen (DE)
(86) Internationale Anmeldenummer: PCT/EP2010/070920
(87) Internationale Veröffentlichungsnummer: WO 2011/088961

(56) Entgegenhaltungen:
- EP-A2- 1 505 857
- EP-A2- 2 034 812
- US-A- 4 401 355
- US-A1- 2007 296 271

## Beschreibung

Die Erfindung betrifft eine Elektronikvorrichtung. Des Weiteren betrifft die Erfindung ein Herstellungsverfahren für eine Elektronikvorrichtung.

### Stand der Technik

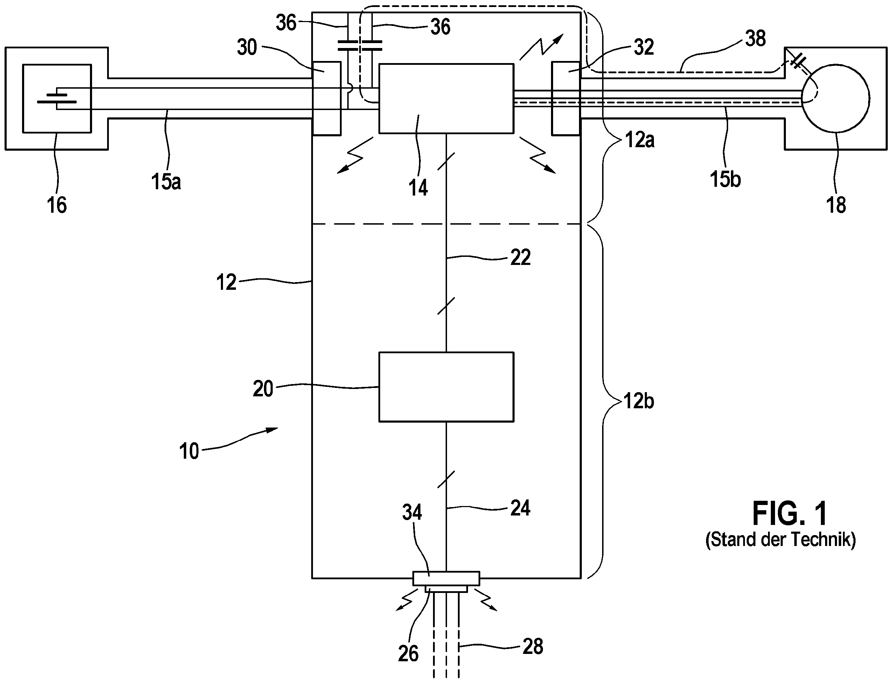

Fig. 1 zeigt eine schematische Darstellung einer herkömmlichen Elektronikvorrichtung. Ein Beispiel für eine derartige Elektronikvorrichtung ist beispielsweise der in der US 2007/02 96 271 A1 beschriebene Energiewandler.

Die schematisch dargestellte Elektronikvorrichtung 10 weist ein (erweitertes) Gehäuse 12 auf, welches (schematisch) zumindest in einen Hochvoltbereich 12a und in einen Niedervoltbereich 12b unterteilbar ist. In dem Hochvoltbereich 12a ist zumindest eine Invertiereinrichtung 14 angeordnet, welche eingangsseitig über eine erste elektrische Verbindung 15a mit einer Batterie 16 und ausgangsseitig über eine zweite elektrische Verbindung 15b mit einem Motor 18 elektrisch verbunden ist. Der Niedervoltbereich 12b weist mindestens eine Komponente 20 zum Betreiben der Elektronikvorrichtung 10 auf. Die schematisch wiedergegebene mindestens eine Komponente 20 des Niedervoltbereichs 12b ist über eine erste interne Leitung 22 elektrisch mit der Invertiereinrichtung 14 verbunden. Eine zweite interne Leitung 24 verbindet die mindestens eine Komponente 20 des Niedervoltbereichs 12b mit einem an dem Gehäuse 12 angebrachten Steckanschluss 26, an welchem eine externe Leitung 28 für eine leitende Verbindung zwischen der Elektronikvorrichtung 10 und einem weiteren (nicht skizzierten) Gerät ankoppelbar ist.

Zum Herausfiltern von elektromagnetischen Störungen, welche in dem Hochvoltbereich 12a, insbesondere aufgrund von parasitären Kapazitäten der Maschinenwicklung auftreten können, kann die Elektronikvorrichtung 10 zusätzlich mit Filterblöcken 30 bis 34 ausgestattet sein. Die dargestellte Elektronikvorrichtung 10 weist einen ersten Filterblock 30 auf, welcher innerhalb der ersten elektrischen Verbindung 15a zwischen der Batterie 16 und der Invertiereinrichtung 14 angeordnet ist. Ein zweiter Filterblock 32 ist in der zweiten elektrischen Verbindung 15b von der Invertiereinrichtung 14 zu dem Motor 18 angeordnet. Ein dritter Filterblock 34 des Niedervoltbereichs 12b ist zwischen der zweiten Leitung 24 und dem Steckanschluss 26 angeordnet. Üblicher Weise ist jeder der Filterblöcke 30 bis 34 als eine spezielle Filterbaugruppe ausgebildet. Ein derartiger Filterblock 30 bis 34 kann als Einheit aus mehreren Kondensatoren und Induktivitäten bestehen, und mindestens ein y-Kondensator 36 kann der elektromagnetischen Störung eine niederimpedante Bahn 38 als Rückführbahn zur Verfügung stellen.

Die Druckschrift US 4,401,355 A offenbart einen Filterverbinder mit einem Tiefpassfilter, welcher teilweise in einem Metallkopf angeordnet ist, welcher elektromagnetische Störungen abschirmt. Die Druckschrift EP 1 507 857 A2 offenbart eine Leiterplattenanordnung mit integrierten Filterverbindern zwischen benachbarten Leiterplatten.

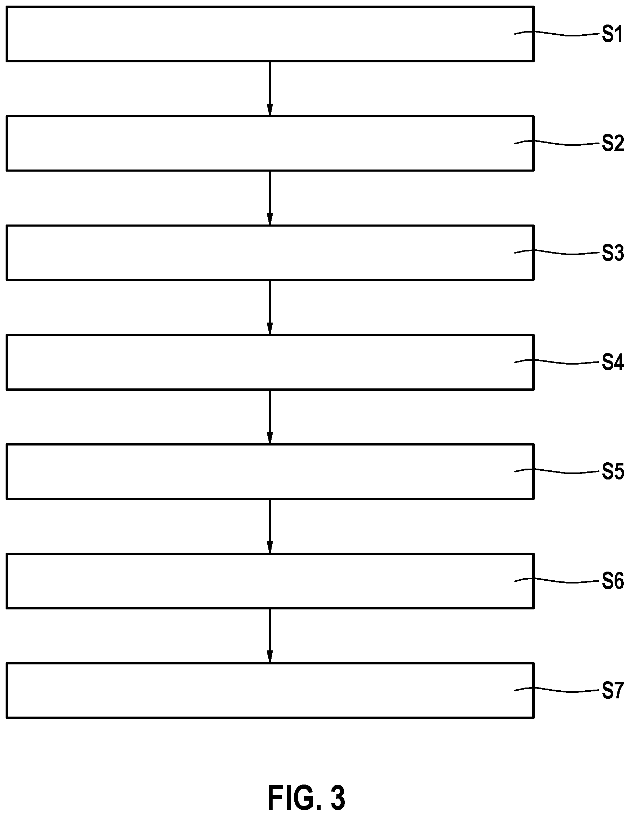

Die Druckschrift EP 2 034 812 A1 offenbart eine serielle Platine für eine Mittelspannungs-Motor-Antriebs-System insbesondere ein modulares Verbindungssystem für einen Antriebsmotor. Die Figur 3 offenbart dort als Stand der Technik ein leitfähiges Gehäuse, in dem ein Inverter und mehrere Leiterplatten mittels mehrerer galvanischer Verbindungen elektrisch untereinander verbunden sind.

### Offenbarung der Erfindung

Die Erfindung schafft eine Elektronikvorrichtung mit den Merkmalen des Anspruchs 1 und ein Herstellungsverfahren für eine Elektronikvorrichtung mit den Merkmalen des Anspruchs 10.

Die vorliegende Erfindung ermöglicht ein Entstörkonzept einer Elektronikvorrichtung mittels mehrerer auf den mindestens zwei Leiterplatten angeordneter Filter, deren Anordnung man auch als ein "In-Reihe-Schalten" der auf den Leiterplatten angeordneten Filter bezeichnen kann. Mittels des Entstörkonzepts sind hochfrequente, energiereiche Störungen auf einfache Weise herausfilterbar. Im Gegensatz zu der herkömmlichen Verwendung von aufwändigen Filtern im Niedervoltbereich/Hochvoltbereich, welche in der Regel sehr teuer sind und viel Bauraum erfordern, ist das erfindungsgemäße Entstörkonzept unter Verwendung von kostengünstigen und wenig Bauraum erfordernden Filtern ausführbar.

Die erfindungsgemäße Elektronikvorrichtung und das entsprechende Herstellungsverfahren bieten somit insbesondere eine Reduktion des Bauraums der Elektronikvorrichtung bei geringeren Herstellungskosten und/oder eine bessere Entstörung.

Die Erfindung ist vor allem für eine Elektronikvorrichtung mit einem Hochvoltbereich vorteilhaft, in welchem energiereiche hochfrequente Störungen auftreten können, die herkömmlicher Weise innerhalb des Gehäuses koppeln können und elektromagnetische Hohlraummoden in Verbindung vor allem mit den angeschlossenen, zusammenwirkenden Geräten, beispielsweise einem Motor, einer Elektromaschine, einer Batterie und/oder einem Generator erzeugen können. Demgegenüber werden die in der Invertiereinrichtung (Inverter, Doppelinverter) der erfindungsgemäßen Elektronikvorrichtung erzeugten hochfrequenten Störungen im Inneren der Elektronikvorrichtung auf andere Baugruppen/Leiterplatten /Hybride übertragen, wobei empfindliche Bauteile/Baugruppen mit kostengünstigen Filtern entstört werden. Somit bietet die vorliegende Erfindung eine kostengünstig und wenig Bauraum erfordernde Filterung der Verbindungsleitungen zwischen den Leiterplatten zum Gehäusepotential hin und damit eine Abschottung der Verbindungswege/Koppelwege aus dem Gerät, insbesondere aus dem geschlossenen und geschirmten Hochvoltbereich, in die Umwelt.

Gegenüber einer Schirmung mittels einer Blechverkleidung einer Leiterplatte, welche aufgrund eines zum elektrischen Kontaktieren der Leiterplatte notwendigen Durchführungsloches kein Abschirmen der Leiterplatte gegenüber elektromagnetischen Störungen ermöglicht, kann mittels des "In-Reihe-Schaltens" der kostengünstigen Filter auch ein auf einer Leiterplatte angeordnetes elektrisches Bauteil vor elektromagnetischen Störungen geschützt werden. Dies ist insbesondere gewährleistet, wenn an den Verbindungssteckern auf den Leiterplatten mehrstufige kostengünstige und wenig Bauraum erfordernde Filter mit jeweils einer Störableitung zum Gehäusepotential eingesetzt werden.

Das "In-Reihe-Schalten" von mindestens drei Filtern gemäß dem hier beschriebenen Entstörkonzept gewährleistet insbesondere ein verlässliches Herausfiltern von hochfrequenten Signalen, als welche die elektromagnetischen Störungen in der Regel auftreten. Demgegenüber werden Nutzsignale, welche meistens mit einer geringeren Frequenz übertragen werden, durch das Entstörkonzept nicht gedämpft.

Bereits ein "In-Reihe-Schalten" von drei Filtern gemäß dem hier beschriebenen Entstörkonzept gewährleistet ein verlässliches Herausfiltern von elektromagnetischen Störungen. Somit kann die zweite Leiterplatte über die zweite galvanische Verbindung beispielsweise mit einem in dem Gehäuse angeordneten Außenkontakt elektrisch verbunden sein, wobei aufgrund des "In-Reihe-Schaltens" der drei Filter gewährleistet ist, dass elektromagnetische Störsignale nicht über eine an dem Außenkontakt angekoppelte elektrische Verbindung an ein externes Gerät weitergeleitet werden.

In einer vorteilhaften Weiterbildung ist die zweite Leiterplatte über die zweite galvanische Verbindung mit einer dritten Leiterplatte als der mindestens einen in dem Gehäuse angeordneten Komponente elektrisch verbunden. Des Weiteren kann die dritte Leiterplatte über eine dritte galvanische Verbindung mit mindestens einer in dem Gehäuse und/oder an dem Gehäuse angebrachten weiteren Komponente der Elektronikvorrichtung elektrisch verbunden sein. Bevorzugter Weise umfasst die Elektronikvorrichtung in diesem Fall einen vierten Filter mit einer vierten Ableitverbindung zu dem Gehäuse, welcher auf der dritten Leiterplatte angeordnet ist und der zweiten galvanischen Verbindung nachgeschaltet ist, und einen fünften Filter mit einer fünften Ableitverbindung zu dem Gehäuse, welcher auf der dritten Leiterplatte angeordnet und der dritten galvanischen Verbindung vorgeschaltet ist. Dieses "In-Reihe-Schalten" gewährleistet auch bei einer Verwendung von fünf vorzugsweise kostengünstigen Filtern ein verlässliches Herausfiltern von elektromagnetischen Störungen. Auf diese Weise ist sichergestellt, dass die über die dritte galvanische Verbindung mit der dritten Leiterplatte verbundene weitere Komponente der Elektronikvorrichtung vor elektromagnetischen Störungen verlässlich abgeschirmt ist. Insbesondere kann die dritte Leiterplatte über die dritte galvanische Verbindung mit einem in dem Gehäuse angeordneten Außenkontakt als weitere Komponente der Elektronikvorrichtung elektrisch verbunden sein. In diesem Fall ist gewährleistet, dass ein an dem Außenkontakt elektrisch angekoppeltes externes Gerät vor den elektromagnetischen Störungen sicher geschützt ist.

Es wird darauf hingewiesen, dass die Elektronikvorrichtung nicht auf eine Anzahl von drei Leiterplatten und/oder fünf Filtern beschränkt ist. Die zusätzliche Ausstattung der Elektronikvorrichtung mit dem vierten und dem fünften Filter ist optional. Ebenso kann die Elektronikvorrichtung mehr als drei Leiterplatten und/oder fünf Filter aufweisen.

Der erste Filter, der zweite Filter, der dritte Filter, der vierte Filter und/oder der fünfte Filter können als T-Filter ausgebildet sein. Somit sind kostengünstige und wenig Bauraum erfordernde Filter für die Elektronikvorrichtung verwendbar. Gleichzeitig ist auch bei einer Verwendung derartiger kostengünstiger und kleiner T-Filter das vorteilhafte Entstören gewährleistet.

Die erste galvanische Verbindung, die zweite galvanische Verbindung und/oder die dritte galvanische Verbindung können jeweils mindestens einen Draht und/oder ein Kabel umfassen.

Bevorzugter Weise umfassen die erste galvanische Verbindung ein erstes Flachbandkabel, die zweite galvanische Verbindung ein zweites Flachbandkabel und/oder die dritte galvanische Verbindung ein drittes Flachbandkabel. Eine derartige Ausbildung der ersten galvanischen Verbindung, der zweiten galvanischen Verbindung und/oder der dritten galvanischen Verbindung bewirkt eine Induktivität der jeweiligen galvanischen Verbindung für hochfrequente Störungen. Demgegenüber werden Nutzsignale problemlos über ein Flachbandkabel übertragen. Somit bewirkt mindestens eine galvanische Verbindung mit einem Flachbandkabel ein verlässliches Herausfiltern von Störungen bei einem gleichzeitigen ungestörten Übertragen von Nutzsignalen. Anstelle eines Flachbandkabels kann mindestens eine der oben genannten galvanischen Verbindungen auch eine andere Kabelart und/oder einen Draht umfassen.

Beispielsweise kann das erste Flachbandkabel, das zweite Flachbandkabel und/oder das dritte Flachbandkabel eine Länge in einem Bereich zwischen 5 cm bis 50 cm und/oder eine Breite in einem Bereich zwischen 3 cm bis 10 cm haben. Vorteilhafter Weise weist das mindestens eine Flachbandkabel eine Länge zwischen 10 cm bis 30 cm, bevorzugter Weise zwischen 15 cm bis 25 cm auf. Die Breite des mindestens einen Flachbandkabels kann insbesondere in einem Bereich zwischen 5 cm bis 10 cm liegen. Bei einer derartigen Ausbildung des mindestens einen Flachbandkabels ist ein verlässliches Herausfiltern der hochfrequenten Störsignale bei einem gleichzeitigen ungestörten Übertragen der gewünschten Nutzsignale auf kostengünstige Weise sicher gewährleistet.

Erfindungsgemäß wirken der erste Filter, die erste galvanische Verbindung und der zweite Filter als ein erster Pi-Filter (π-Filter) zusammen. Insbesondere können der dritte Filter, die zweite galvanische Verbindung und der vierte Filter als ein zweiter Pi-Filter (π-Filter) zusammenwirken. Bevorzugter Weise sind die Filter und die galvanischen Verbindungen so ausgebildet, dass man von einem "In-Reihe-Schalten" von Pi-Filtern sprechen kann. Ein derartiges Filterkonzept ist kostengünstig ausführbar und erfordert wenig Bauraum. Gegenüber einem herkömmlichen Filter weist ein derartiges Filterkonzept mit mindestens einem derart ausgebildeten Pi-Filter ein vorteilhaftes Filterverhalten auf, ist kostengünstig herstellbar und erfordert wenig Bauraum.

In einer Weiterbildung kann die Elektronikvorrichtung mindestens eine plattenförmige Abschirmeinheit, welche zumindest teilweise aus einem leitfähigen Material ausgebildet und mit der zugeordneten Ableitverbindung des ersten, zweiten, dritten, vierten und/oder fünften Filters und dem Gehäuse elektrisch verbunden ist, umfassen. Eine derartige Abschirmeinheit, beispielsweise ein Schirmblech und/oder eine Gehäuseformung, verbessert das Herausfiltern der unerwünschten Störsignale und vermindert die Modenstörung. Zusätzlich ist eine derartige Abschirmeinheit kostengünstig herstellbar. Die Abschirmeinheit erfordert kaum einen zusätzlichen Bauraum an der Elektronikvorrichtung. Insbesondere kann die Elektronikvorrichtung mehrere derartige Abschirmeinheiten umfassen, welche in einem elektrischen Kontakt mit den Ableitverbindungen verschiedener Filter angeordnet sind. Zusätzlich erwirken die beschriebenen Filter und die mindestens eine plattenförmige Abschirmeinheit auch ein Bedämpfen von elektromagnetischen Moden, die sonst über einen Niedervolt-Anschluss unkontrolliert in die Umwelt gelangen könnten.

Beispielsweise kann auf der ersten Leiterplatte eine Invertersteuerung, auf der zweiten Leiterplatte eine Steuerelektronik und/oder auf der dritten Leiterplatte eine Steckerelektronik ausgebildet sein. Derartige Leiterplatten sind für ein breites Spektrum von Elektronikvorrichtungen, beispielsweise in einer Leistungselektronik, in einem Pulswechselrichter oder in einem Wandler, vorteilhaft verwendbar.

Die Elektronikvorrichtung kann als Leistungselektronik, als Pulswechselrichter, als Hybridmotor und/oder als DC/DC- Wandler ausgebildet sein. Eine derartige Ausbildung der Elektronikvorrichtung ist aufgrund des vorteilhaften Filterkonzepts der Elektronikvorrichtung vor allem in einem Fahrzeug zur Gewährleistung eines hohen Sicherheitsstandards einsetzbar.

Die in den oberen Absätzen beschriebenen Vorteile sind auch mittels eines entsprechenden Herstellungsverfahrens realisierbar.

### Kurze Beschreibung der Zeichnungen

Weitere Merkmale und Vorteile der vorliegenden Erfindung werden nachfolgend anhand der Figuren erläutert. Es zeigen:
- Fig. 1: eine schematische Darstellung einer herkömmlichen Elektronikvorrichtung;
- Figur 2: eine schematische Darstellung einer Ausführungsform der Elektronikvorrichtung; und
- Fig. 3: ein Flussdiagramm zum Darstellen einer Ausführungsform des Herstellungsverfahrens für eine Elektronikvorrichtung.

### Ausführungsformen der Erfindung

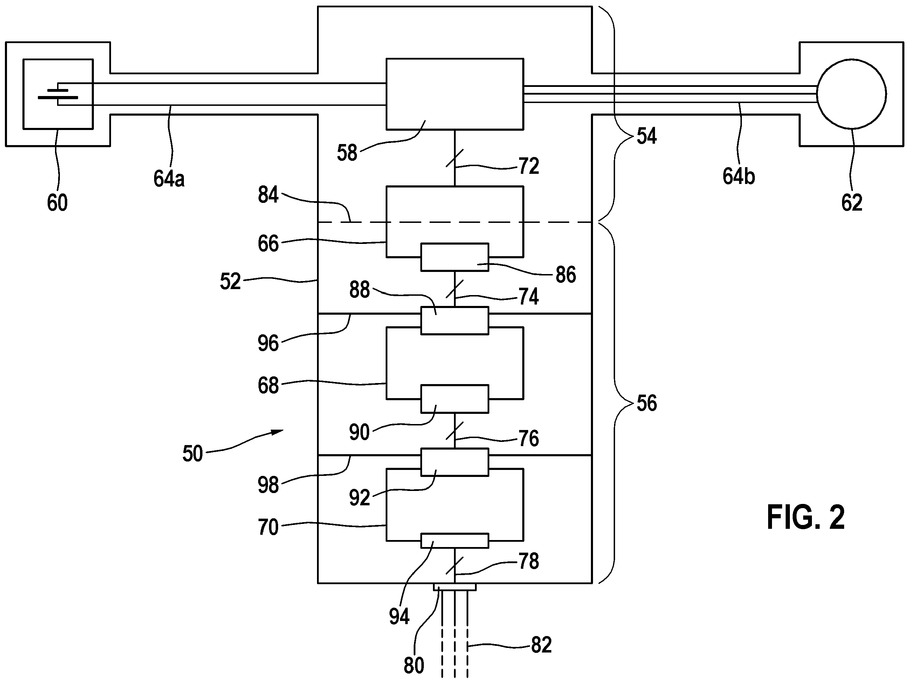

Figur 2 zeigt eine schematische Darstellung einer Ausführungsform der Elektronikvorrichtung.

Die in Figur 2 schematisch dargestellte Elektronikvorrichtung 50 weist ein (erweitertes) Gehäuse 52 auf, welches zumindest teilweise aus einem leitfähigen Material ausgebildet ist. Das leitfähige Material des Gehäuses 52 kann ein Metall und/oder ein dotiertes Halbleitermaterial sein. Bevorzugter Weise ist das Gehäuse 52 vollständig aus dem leitfähigen Material gebildet.

Bei der dargestellten Ausführungsform ist der Innenraum des Gehäuses 52 (schematisch) zumindest in einen als Hochvoltbereich 54 ausgebildeten Störbereich und mindestens einen als Niedervoltbereich 56 ausgebildeten durch die im Weiteren beschriebene Filterung entkoppelten Bereich unterteilbar. Die Elektronikvorrichtung 50 ist jedoch nicht auf eine derartige Unterteilung in mindestens einen Störbereich und mindestens einen entkoppelten Bereich oder in deren Ausbildung als Hochvoltbereich 54 und Niedervoltbereich 56 beschränkt. Stattdessen soll die dargestellte Unterteilung lediglich beispielhaft demonstrieren, dass die im Weiteren beschriebene erfindungsgemäße Technologie auch auf eine Elektronikvorrichtung 50 anwendbar ist, bei welcher während eines Betriebs der Elektronikvorrichtung 50 eine hohe Spannung an mindestens eine Komponente angelegt wird, während für mindestens eine andere Komponente der Elektronikvorrichtung 50 das Anlegen einer deutlich reduzierten Spannung bevorzugt wird.

Die dargestellte Elektronikvorrichtung 50 weist eine Invertiereinrichtung 58 auf, welche vorzugsweise in dem Hochvoltbereich 54 angeordnet ist. Die Invertiereinrichtung 58, welche beispielsweise auch als Inverter und/oder als Wandler (z.B. als DC/DC-Wandler) bezeichenbar ist, kann mindestens einen Bipolartansistor mit isolierter Gate-Elektrode (IGBT, Insulated-Gate Bipolar Transistor) umfassen. Optional können innerhalb des Gehäuses 52 auch eine Batterie 60 und/oder ein Motor 62 (Elektro-Motor) angeordnet sein. Da die Elektronikvorrichtung 50, wie unten genauer beschrieben, mit einer deutlich reduzierten Ausdehnung/mit einem deutlich reduzierten Bauraumbedarf ausbildbar ist, ist das zusätzliche Anordnen der Batterie 60 und/oder des Motors 62 innerhalb des Gehäuses 52, vorzugsweise in dem Hochvoltbereich 54, einfach ausführbar. In diesem Fall ist es möglich, die Invertiereinrichtung 58 über je eine einfach und kostengünstig ausführbare elektrische Verbindung mit der Batterie 60 und/oder dem Motor 62 zu verbinden. Beispielsweise kann eine erste Hochspannungsleitung 64a innerhalb des Gehäuses 52 von der Batterie 60 zu der Invertiereinrichtung 58 verlaufen. Entsprechend kann eine ebenfalls in dem Gehäuse 52 angeordnete zweite Hochspannungsleitung 64b die Invertiereinrichtung 58 elektrisch mit dem Motor 62 verbinden. In diesem Fall gewährleistet das Gehäuse 52 zusätzlich ein Abschirmen der Hochspannungsleitungen 64a und 64b.

Die Elektronikvorrichtung 50 umfasst zusätzlich zu der Invertiereinrichtung 58 mindestens zwei innerhalb des Gehäuses 52 angeordnete Leiterplatten 66 bis 70. Bei der dargestellten Ausführungsform weist die Elektronikvorrichtung 50 drei Leiterplatten 66 bis 70 auf. Die Ausführbarkeit der hier beschriebenen Elektronikvorrichtung 50 ist jedoch nicht auf eine bestimmte Anzahl von Leiterplatten 66 bis 70 beschränkt. Unter einer Leiterplatte 66 bis 70 ist dabei auch eine PCB-Einheit (Printed Circuit Board), eine Leiterkarte, eine Platine, eine gedruckte Schaltung, ein Hybrid und/oder einer entsprechenden Einheit als Träger für mindestens ein elektrisches Bauteil zu verstehen. Der im Weiteren verwendete Begriff Leiterplatte 66 bis 70 umfasst alle die hier aufgezählten Ausführungsformen. In der Regel besteht eine derartige Leiterplatte 66 bis 70 aus einem elektrisch isolierenden Material mit daran haftenden leitenden Verbindungen (Leiterbahnen). Bevorzugter Weise erfüllt die Leiterplatte 66 bis 70 eine Multifunktionalität zur mechanischen Befestigung und/oder elektrischen Verbindung des darauf ausgebildeten Bauteils. Die hier beschriebene Elektronikvorrichtung 50 ist nicht auf eine bestimmte Ausführung einer verwendbaren Leiterplatte 66 bis 70, beispielsweise auf ein bestimmtes isolierendes Material, auf ein bestimmtes Schaltmuster der Leiterbahnen oder auf das darauf ausgebildete elektrische Bauteil beschränkt. Da nahezu jedes elektrisches Gerät somit mindestens zwei derartige Leiterplatten 66 bis 70 umfasst, ist die nachfolgend beschriebene Technologie auf eine große Anzahl von elektrischen Geräten anwendbar.

Eine erste Leiterplatte 66 ist über mindestens eine Leitung 72 mit der Invertiereinrichtung 58 elektrisch verbunden. Eine zweite Leiterplatte 68, welche über eine erste galvanische Verbindung 74 mit der ersten Leiterplatte 66 elektrisch verbunden ist, ist über eine zweite galvanische Verbindung 76 mit der dritten Leiterplatte 70 elektrisch verbunden. Die dritte Leiterplatte 70 ist über eine dritte galvanische Verbindung 78 mit einem an dem Gehäuse 52 angeordneten Außenkontakt 80 der Elektronikvorrichtung 50, beispielsweise mit einem Steckanschluss, elektrisch verbunden. An dem Außenkontakt 80 kann beispielsweise eine externe Leitung 82 ankoppelbar sein, mittels welcher die Elektronikvorrichtung 50 mit einem weiteren (nicht skizzierten) Gerät elektrisch verbindbar ist. Es wird jedoch darauf hingewiesen, dass die Elektronikvorrichtung 50 nicht auf eine die dritte Leiterplatte 70 mit einem Außenkontakt 80 elektrisch verbindende dritte galvanische Verbindung 78 beschränkt ist. Anstelle des Außenkontakts 80 kann die dritte Leiterplatte 70 über die dritte galvanische Verbindung 78 beispielsweise auch mit einer anderen in dem Gehäuse 52 und/oder an dem Gehäuse 52 angeordneten Komponente der Elektronikvorrichtung 50 elektrisch verbunden sein.

Die erste Leiterplatte 66 kann beispielsweise so in dem Gehäuse 52 angeordnet sein, dass ein Grenzbereich 84 zwischen dem Hochvoltbereich 54 und dem Niedervoltbereich 56 die erste Leiterplatte 66 schneidet. Die zweite Leiterplatte 68 und die dritte Leiterplatte 70 können in diesem Fall innerhalb des Niedervoltbereichs 56 angeordnet werden. Es wird jedoch darauf hingewiesen, dass die Elektronikvorrichtung 50 nicht auf eine derartige Positionierung der Leiterplatten 66 bis 70 beschränkt ist.

Die erste Leiterplatte 66 kann über die Leitung 72 mittelbar oder unmittelbar an die Invertiereinrichtung 58 angekoppelt sein. Beispielsweise kann die erste Leiterplatte 66 über die Leitung 72 mit einer weiteren Komponente der Elektronikvorrichtung 50 elektrisch verbunden sein, welche ihrerseits mittelbar oder unmittelbar über eine weitere Leitung an die Invertiereinrichtung 58 elektrisch angekoppelt ist. Auf ein Darstellen einer derartigen Ausbildung der Elektronikvorrichtung 50 wird in Figur 2 jedoch verzichtet.

Die Leitung 72, über welche die erste Leiterplatte 66 mit der Invertiereinrichtung 58 elektrisch verbunden ist, kann beispielsweise ein Kabel, insbesondere ein Flachbandkabel sein. Eine derartige Ausbildung der Leitung 72 ist für die Realisierung der Elektronikvorrichtung 50 jedoch nicht erforderlich.

Die Ausbildbarkeit der Elektronikvorrichtung 50 ist nicht auf die dargestellte Anzahl von galvanischen Verbindungen 74 bis 78 beschränkt. Stattdessen kann die Anzahl der galvanischen Verbindungen 74 bis 78 der Elektronikvorrichtung 50 gleich zwei oder mindestens gleich vier sein. Mindestens eine der galvanischen Verbindungen 74 bis 78 kann eine elektrische Verbindung sein. Bevorzugter Weise umfasst mindestens eine der galvanischen Verbindungen 74 bis 78 ein Flachbandkabel oder ist als Flachbandkabel ausgebildet. In einer vorteilhaften Ausführungsform der Elektronikvorrichtung 50 umfasst die erste galvanische Verbindung 74 ein erstes Flachbandkabel, die zweite galvanische Verbindung 76 ein zweites Flachbandkabel und die dritte galvanische Verbindung 78 ein drittes Flachbandkabel. Eine Länge des mindestens einen Flachbandkabels kann in einem Bereich zwischen 5 bis 50 cm, vorzugsweise zwischen 10 bis 30, insbesondere zwischen 15 bis 25 liegen. Eine Breite des mindestens einen Flachbandkabels kann in einem Bereich zwischen 3 bis 12 cm, bevorzugter Weise zwischen 5 bis 10 cm liegen. Derartige kostengünstige Flachbandkabel können mehrere Einzelleitungen, beispielsweise 42 Einzelleitungen (42 Zuleitungen) umfassen. Auf die Vorteile einer Ausstattung der Elektronikvorrichtung 50 mit mindestens einer als Flachbandkabel ausgebildeten galvanischen Verbindung 74 bis 78 wird nachfolgend noch genauer eingegangen. Es wird darauf hingewiesen, dass trotz der Verwendung des Schaltsymbols für mehrere Leitungen die Leitung 72 und die galvanischen Verbindungen 74 bis 78 jedoch nicht auf eine Ausstattung mit einem mehrere Leitungen umfassenden Kabel beschränkt sind.

Die Elektronikvorrichtung 50 weist einen ersten Filter 86 mit einer ersten Ableitverbindung zu dem Gehäuse 52 auf. Der erste Filter 86 ist auf der ersten Leiterplatte 66 angeordnet. Außerdem ist der erste Filter 86 der ersten galvanischen Verbindung 74 vorgeschaltet. Unter einem Vorschalten des ersten Filters 86 vor der ersten galvanischen Verbindung 74 ist vorzugsweise zu verstehen, dass der erste Filter 86 eingangsseitig an mindestens ein auf der ersten Leiterplatte 66 angeordnetes Bauteil elektrisch angekoppelt und ausgangsseitig elektrisch mit der ersten galvanischen Verbindung 74 verbunden ist. Ein Stromfluss zwischen dem mindestens einen auf der ersten Leiterplatte 66 angeordneten Bauteil und der ersten galvanischen Verbindung 74 erfolgt somit über den ersten Filter 86.

Auf der zweiten Leiterplatte 68 ist ein zweiter Filter 88 mit einer zweiten Ableitung zu dem Gehäuse 52 angeordnet. Der zweite Filter 88 ist der ersten galvanischen Verbindung 74 nachgeschaltet. Unter einem Nachschalten des zweiten Filters 88 nach der ersten galvanischen Verbindung 74 kann vorzugsweise verstanden werden, dass der zweite Filter 88 eingangsseitig elektrisch mit der ersten galvanischen Verbindung 74 verbunden ist und ausgangsseitig an mindestens ein auf der zweiten Leiterplatte 68 angeordnetes Bauteil elektrisch angekoppelt ist. Bevorzugter Weise erfolgt ein Stromfluss zwischen der ersten galvanischen Verbindung 74 und dem mindestens einen auf der zweiten Leiterplatte 68 angeordneten Bauteil über den zweiten Filter 88.

Auf der zweiten Leiterplatte 68 ist auch ein dritter Filter 90 mit einer dritten Ableitverbindung zu dem Gehäuse 52 angeordnet. Der dritte Filter 90 ist der zweiten galvanischen Verbindung 76 vorgeschaltet. Zur Erläuterung des Vorschaltens des dritten Filters 90 vor die zweite galvanische Verbindung 76 wird auf die obere Umschreibung des Vorschaltens des ersten Filters 86 vor die erste galvanische Verbindung 74 verwiesen.

Bevorzugter Weise sind auf der dritten Leiterplatte 70 ein vierter Filter 92 mit einer vierten Ableitverbindung zu dem Gehäuse 52 und/oder ein fünfter Filter 94 mit einer fünften Ableitverbindung zu dem Gehäuse 52 angeordnet. In einer bevorzugten Ausführungsform der Elektronikvorrichtung 50 ist der vierte Filter 92 der zweiten galvanischen Verbindung 76 nachgeschaltet und/oder der fünfte Filter 94 der dritten galvanischen Verbindung 78 vorgeschaltet. Zur Erläuterung der Begriffe "Vorschalten" und "Nachschalten" wird auf die oberen Absätze verwiesen.

Mindestens einer der mindestens drei Filter 86 bis 94 kann an einem Verbindungsstecker der der vor- oder nachgeschalteten galvanischen Verbindung 74 bis 78 auf der zugeordneten Leiterplatte 66 bis 70 angeordnet werden. Eine derartige Anordnung mindestens eines Filters 86 bis 94 ist mit geringem Aufwand ausführbar und gewährleistet ein verlässliches Herausfiltern von Störsignalen. Man kann diese Anordnung der Filter 86 bis 94 auch als Anordnen an den Steckverbindungen der Leiterplatten 66 bis 70 umschreiben.

Der erste Filter 86, der zweite Filter 88, der dritte Filter 90, der vierte Filter 92 und/oder der fünfte Filter 94 kann als T-Filter ausgebildet sein. Unter einem T-Filter ist dabei ein Filter zu verstehen, dessen Schaltkreistopologie wie der Buchstabe T aussieht. In der Regel ist in die Signalleitung eines derartigen T-Filters mindestens ein Bauelement wie ein Widerstand, ein Kondensator, eine Induktivität und/oder eine komplexere Schaltung angeordnet (eingeschleift), wobei von einem in der Signalleitung angeordneten Knotenpunkt ein Abgriff (Ableitverbindung) zu dem Gehäuse 52 führt, in welchem ein Kondensator bzw. ein entsprechendes Bauelement (eine komplexere Schaltung) angeordnet ist. Ein für die Filter 86 bis 94 verwendbarer T-Filter kann beispielsweise als T-Tiefpassglied mit zwei Widerständen in der Signalleitung und einem Kondensator in der Ableitverbindung zu dem Gehäuse 52, als T-Tiefpassglied mit zwei Induktivitäten in der Signalleitung und einem Kondensator in der Ableitverbindung zu dem Gehäuse 52 und/oder als T-Hochpassglied mit zwei Kondensatoren in der Signalleitung und einem Widerstand in der Ableitverbindung zu dem Gehäuse 52 ausgebildet sein. Die Ausbildung der Filter 86 bis 94 ist jedoch nicht auf einen T-Filter, insbesondere auf ein T-Tiefpassglied oder auf ein T-Hochpassglied, beschränkt.

Die mindestens drei Filter 86 bis 94 können aufgrund des jeweiligen Kondensators der Ableitverbindung zu dem Gehäuse 52 auch als SMD-Bauteile (Service Mounted Device) bezeichnet werden. Als für die mindestens drei Filter 86 bis 94 verwendbares SMD-Bauteil kann eine kostengünstige und einfach verbaubare Kapazität verwendet werden, deren Leiterplatte eine Masseverbindung zu dem Gehäuse 52 aufweist. Die Ableitverbindung eines Filters 86 bis 94 ist somit über einen Kondensator leicht vornehmbar. Insbesondere können die Filter 86 bis 94 auch bei einer vergleichsweise kleinen Ausdehnung und/oder bei einem geringen Gewicht ihre nachfolgend genauer beschriebene Funktion sicher ausführen. Somit ist die Ausstattung der Elektronikvorrichtung 50 mit den mindestens drei Filtern 86 bis 94 nicht mit einer signifikanten Gewichtszunahme der Elektronikvorrichtung 50 und/oder mit einem größeren Bauraumbedarf der Elektronikvorrichtung 50 verbunden.

Der mindestens eine T-Filter kann an einem ersten Ende der Signalleitung ein auf der zugeordneten Leiterplatte 66 bis 70 angeordnetes Bauteil kontaktieren. Ein zweites Ende der Signalleitung kann in der vor- oder nachgeschalteten galvanischen Verbindung 74 bis 78 münden. Eine derartige Anordnung des mindestens einen T-Filters gewährleistet ein besonders gutes Herausfiltern von Störsignalen.

In einer Weiterbildung der dargestellten Elektronikvorrichtung 50 kann auch mindestens eine vierte Leiterplatte mit vorzugsweise zwei derartigen Filtern ausgestattet werden. Beispielsweise kann ein sechster Filter der dritten galvanischen Verbindung 78 nachgeschaltet sein, während ein siebter Filter einer weiteren galvanischen Verbindung vorgeschaltet ist. Entsprechend den oben beschriebenen Filtern 86 bis 94 können der sechste und der siebte Filter je eine Ableitverbindung zu dem Gehäuse 52 aufweisen. Da für den sechsten Filter und/oder für den siebten Filter die oben schon aufgezählten kostengünstigen, leichten und/oder wenig Bauraum erfordernden Ausführungsformen verwendbar sind, ist eine zusätzliche Weiterbildung der Elektronikvorrichtung 50 mit mindestens zwei weiteren Filtern nicht mit signifikant erhöhten Herstellungskosten, einer deutlichen Gewichtszunahme und/oder einem größeren Bauraumbedarf verbunden. Das anhand der Figur 2 dargestellte und nachfolgend genauer erläuterte Filterkonzept mittels der Filter 86 bis 94 ist somit auf eine größere Anzahl von Filtern erweiterbar. Die Vorteile der hier beschriebenen Elektronikvorrichtung 50 ergeben sich dadurch, dass es mittels des "In-Reihe-Schaltens" zumindest des ersten Filters 86, des zweiten Filters 88 und des dritten Filters 90 auf die oben beschriebene Weise möglich ist, hochfrequente Störungen gezielt herauszufiltern, das heißt über das Gehäuse 52 abzuleiten. Diese Filterung mittels zumindest der drei Filter 86 bis 90 beeinträchtigt die Weiterleitung von Nutzsignalen über die galvanischen Verbindungen 74 bis 78 kaum/nicht. Somit bietet die dargestellte Filteranordnung mit zumindest den Filtern 86 bis 90 eine verlässliche, kostengünstige, niedergewichtige, wenig Bauraum erfordernde und gezielt auf hochfrequente Störsignale gerichtete Filterung. Auf diese Weise ist ein Entstörkonzept der Elektronikvorrichtung 50 umfassend ein mehrstufiges, breitbandiges Frequenzfilterkonzept so ausführbar, dass elektromagnetische Störungen, wie sie beispielsweise durch parasitäre Kapazitäten in der Maschinenwicklung entstehen können, über das Gehäuse 52 ableitbar sind. Ein Austreten bzw. Vagabundieren von derartigen elektromagnetischen Störungen in die Umwelt ist somit verlässlich unterbunden.

Das mittels zumindest der Filter 86 bis 90 realisierte Entstörkonzept bietet eine vorteilhafte Alternative zu der herkömmlichen Ausstattung der Elektronikvorrichtung 50 mit Filterblöcken. Da derartige Filterbaugruppen vergleichsweise viel Platz erfordern und hohe Herstellungskosten aufweisen, kann mittels einer Verwendung von zumindest den Filtern 86 bis 90 die Kosten und/oder der Bauraumbedarf für die Elektronikvorrichtung 50 reduziert werden. Zudem ist der Entstöraufwand/Entwicklungsaufwand der herkömmlicher Weise verwendeten Filterblöcke höherer Ordnung sehr hoch und nur realisierbar mit Simulationswerkzeugen und viel Messtechnik. Dieser Nachteil wird mittels des erfindungsgemäßen Entstörkonzepts ebenfalls umgangen.

Da es insbesondere nicht mehr notwendig ist, Filterblöcke im Bereich der elektrischen Verbindungen zwischen der Batterie 60 und der Invertiereinrichtung 58 und zwischen der Invertiereinrichtung 58 und dem Motor 62 anzuordnen, kann die Elektronikvorrichtung 50 auf einfache Weise als Baugruppe mit einem geschlossenen (erweiterten) Gehäuse 52 umfassend geschirmten/geschlossenen Hochvoltbereich 54 mit zur Peripherie geschirmten Hochvoltleitungen und einem Niedervoltbereich 56 ausgebildet werden. Das Entstörkonzept mittels zumindest der Filter 86 bis 90 vergrößert somit auch die Ausbildungsfreiheiten bei der Realisierung der Elektronikvorrichtung 50. Zusätzlich ist im Gegensatz zu den herkömmlichen Filterblöcken, welche keine Schirmung innerhalb des Gehäuses 52 gewährleisten, ein zusätzlicher Abschirmeffekt von einzelnen Komponenten der Elektronikvorrichtung 50 realisierbar.

Die erste galvanische Verbindung 74 und/oder die zweite galvanische Verbindung 76 fungiert dabei für die unerwünschten hochfrequenten Störsignale als eine Induktivität. Dies gewährleistet ein gezieltes Herausfiltern der hochfrequenten Störsignale, wobei gleichzeitig die über die galvanischen Verbindungen 74 bis 78 weiterzuleitenden Nutzsignale nicht/kaum beeinträchtigt werden. Man kann das "In-Reihe-Schalten" der dargestellten Filter 86 bis 94 auch so umschreiben, dass der erste Filter 86, die erste galvanische Verbindung 74 und der zweite Filter 88 als ein erster Pi-Filter (π-Filter) zusammenwirken und/oder der dritte Filter 90, die zweite galvanische Verbindung 76 und der vierte Filter 92 als ein zweiter Pi-Filter (π-Filter) zusammenwirken.

Die vorteilhafte Multifunktionalität mindestens einer der galvanischen Verbindungen 74 bis 78 ist insbesondere gewährleistet, sofern die jeweilige galvanische Verbindung 74 bis 78 ein Flachbandkabel umfasst. Dabei wirkt sich insbesondere eine Länge des Flachbandkabels zwischen 5 bis 50 cm, vorzugsweise zwischen 10 bis 30 cm, bevorzugter Weise zwischen 15 bis 25 cm, vorteilhaft aus. Entsprechend kann auch die Verwendung mindestens eines Flachbandkabels mit einer Breite zwischen 3 bis 12 cm, vorteilhafter Weise zwischen 5 bis 10 cm, die gewünschte Multifunktionalität der jeweiligen galvanischen Verbindung 74 bis 78 gewährleisten. In einer bevorzugten Ausführungsform der Elektronikvorrichtung 50 umfassen die galvanischen Verbindungen 74 bis 78 Flachbandkabel mit einer Länge von 20 cm und einer Breite von 7 cm. Dies gewährleistet das zuvor schon beschriebene gezielte Herausfiltern von hochfrequenten Störungen über einen Frequenzbereich, welcher die in der Regel auftretenden hochfrequenten Störungen verlässlich abdeckt.

Als Ergänzung zu den mindestens drei Filtern 86 bis 90 kann die Elektronikvorrichtung 50 noch mindestens eine plattenförmige Abschirmeinheit 96 oder 98 umfassen, welche zumindest teilweise aus einem leitfähigen Material, wie Metall und/oder einem dotierten Halbleitermaterial, ausgebildet ist. Die mindestens eine plattenförmige Abschirmeinheit 96 und/oder 98 ist in diesem Fall mit einer zugeordneten Ableitverbindung des jeweiligen Filters 86 bis 94, zu welchem sie benachbart angeordnet ist, und mit dem Gehäuse 52 elektrisch verbunden. Eine geeignete plattenförmige Abschirmeinheit 96 und 98 kann beispielsweise ein Schirmblech und/oder eine Gehäuseformung sein.

Die dargestellte Elektronikvorrichtung 50 umfasst beispielhaft eine erste plattenförmige Abschirmeinheit 96, welche mit der Ableitverbindung des zweiten Filters 88 elektrisch verbunden ist, und eine zweite plattenförmige Abschirmeinheit 98, welche mit der Ableitverbindung des vierten Filters 92 elektrisch verbunden ist. Es wird darauf hingewiesen, dass die hier beschriebene Elektronikvorrichtung 50 nicht auf eine Ausstattung mit einer bestimmten Anzahl von Abschirmeinheiten 96 und 98 und/oder auf eine elektrische Ankopplung der mindestens einen Abschirmeinheit 96 oder 98 an eine Ableitverbindung eines bestimmten Filters 86 bis 94 beschränkt ist. Somit ist bei der Herstellung der Elektronikvorrichtung 50 eine vorteilhafte Variationsfreiheit zum Anbringen der mindestens einen Abschirmeinheit 96 und/oder 98 gewährleistet. Das dargestellte Filterkonzept ist somit mit einer Abschirmung mit mindestens einer plattenförmigen Abschirmeinheit 96 und/oder 98 kombinierbar. Beispielsweise kann zusätzlich zu dem Entstörkonzept mittels der Filter 86 bis 94 auch eine Abschirmung über die als Schirmbleche ausgebildeten Abschirmeinheiten 96 und 98 so realisiert sein, dass die einzelnen Leiterplatten 66 bis 70 untereinander abgeschirmt sind. Eine vorteilhafte Güte dieser Filterung ist durch eine Mehrstufigkeit steigerbar.

In einer vorteilhaften Ausführungsform der Elektronikvorrichtung 50 kann auf der ersten Leiterplatte 66 eine Invertersteuerung, auf der zweiten Leiterplatte 68 eine Steuerelektronik und/oder auf der dritten Leiterplatte 70 eine Steckerelektronik ausgebildet sein. Die auch als Gate Treiber bezeichenbare Invertersteuerung ist bevorzugter Weise halb im Hochvoltbereich 54 und halb im Niedervoltbereich 56 angeordnet. Somit ist mittels der Filter 86 bis 94 eine mehrstufige Filteranordnung mit einer ersten Filterstufe am Ausgang des Gate Treibers, einer zweiten Filterstufe am Eingang der Steuerelektronik, mit einer dritten Filterstufe am Ausgang der Steuerelektronik, mit einer vierten Filterstufe am Eingang der Steckerelektronik und mit einer fünften Filterstufe am Ausgang der Steckerelektronik ausgebildet. Die hier beschriebene Elektronikvorrichtung 50 ist jedoch nicht auf eine derartige Ausbildung beschränkt.

Ein weiterer Vorteil der Filter 86 bis 90 bzw. bis 94 ist, dass die Filterung nicht im Hochvoltbereich 54 sondern im Niedervoltbereich 56 ausführbar ist, und somit die Elektronikvorrichtung 50 kostengünstiger herstellbar und ein besseres Leistungsspektrum (z.B. eine verbesserte Temperaturresistenz) aufweist. Beispielsweise kann mittels der hier beschriebenen Filter 86 bis 90 bzw. bis 94 auf die Verwendung von y-Kondensatoren, welche in der Regel keine verlässliche Funktionsweise außerhalb eines vergleichweise engen Temperaturbereichs gewährleisten, verzichtet werden. Somit kann die hier beschriebene, kostengünstig herstellbare Elektronikvorrichtung 50 auch bei extremen Temperaturen verlässlich betrieben werden.

Die in den oberen Absätzen beschriebene Elektronikvorrichtung 50 kann als Leistungselektronik ausgebildet sein. Insbesondere kann die Elektronikvorrichtung 50 als Pulswechselrichter, als Hybridmotor oder als DC/DC - Wandler ausgebildet sein. Es wird jedoch darauf hingewiesen, dass die Anwendbarkeit des in den oberen Absätzen beschriebenen Filterkonzepts mit zumindest den Filtern 86 bis 90 nicht auf eine derart ausgebildete Elektronikvorrichtung 50 beschränkt ist.

Als Ergänzung zu den in Fig. 2 schematisch dargestellten Filtern 86 bis 90 und plattenförmigen Abschirmeinheiten 96 und 98 kann die Elektronikvorrichtung 50 noch weitere Filterkomponenten, wie beispielsweise mindestens eine der in Fig. 1 skizzierten Filterkomponenten und/oder mindestens einen y-Kondensator, umfassen. Auf ein zusätzliches Darstellen einer derartigen Filterkomponente wird in Fig. 2 jedoch verzichtet, um zu veranschaulichen, dass das Entstörkonzept der Filtern 86 bis 90 für einen verlässlichen Schutz vor Störsignalen ausreichend ist.

Fig. 3 zeigt ein Flussdiagramm zum Darstellen einer Ausführungsform des Herstellungsverfahrens für eine Elektronikvorrichtung.

In einem Verfahrensschritt S1 des Herstellungsverfahrens werden eine Invertiereinrichtung, eine erste Leiterplatte und eine zweite Leiterplatte in einem zumindest teilweise aus einem leitfähigen Material ausgebildeten Gehäuse angeordnet. Es wird jedoch darauf hingewiesen, dass die herzustellende Elektronikvorrichtung nicht auf eine Anzahl von genau zwei Leiteplatten beschränkt ist. Somit können auch mehr als zwei Leiterplatten in dem Gehäuse zusammen mit der Invertiereinrichtung angeordnet werden. Optional kann auch mindestens eine weitere Komponente der Elektronikvorrichtung in dem Gehäuse und/oder an dem Gehäuse angeordnet werden.

In einem Verfahrensschritt S2 wird die Invertiereinrichtung über mindestens eine Leitung mit der ersten Leiterplatte elektrisch verbunden. Insbesondere kann die Invertiereinrichtung über eine Hochspannungsleitung mit der ersten Leiterplatte verbunden werden.

In einem Verfahrensschritt S3 wird eine erste galvanische Verbindung zwischen der ersten Leiterplatte und der zweiten Leiterplatte so ausgebildet, dass die erste Leiterplatte mit der zweiten Leiterplatte über die erste galvanische Verbindung elektrisch verbunden wird. Entsprechend wird in einem Verfahrensschritt S4 die zweite Leiterplatte über eine zweite galvanische Verbindung mit mindestens einer in dem Gehäuse und/oder an dem Gehäuse angeordneten Komponente der Elektronikvorrichtung 50 elektrisch verbunden. Bevorzugter Weise wird in mindestens einem der Verfahrensschritte S3 oder S4 ein Flachbandkabel mit einer Länge zwischen 5 bis 50 cm, vorzugsweise zwischen 10 bist 30 cm, insbesondere zwischen 15 bis 25 cm, und einer Breite zwischen 3 bis 12 cm, bevorzugter Weise zwischen 5 bis 10 cm, zwischen der ersten Leiterplatte und der zweiten Leiterplatte und/oder zwischen der zweiten Leiterplatte und der mindestens einen Komponenten angelegt. Entsprechend kann in mindestens einem weiteren Verfahrensschritt zumindest ein weiteres Flachbandkabel zwischen zwei weiteren Leiterplatten der Elektronikvorrichtung 50 angelegt werden.

Des Weiteren wird in einem Verfahrensschritt S5 ein auf der ersten Leiterplatte angeordneter erster Filter mit einer ersten Ableitverbindung zu dem Gehäuse ausgebildet, wobei der erste Filter der ersten galvanischen Verbindung vorgeschaltet wird. Entsprechen wird in einem Verfahrensschritt S6 ein zweiter Filter mit einer zweiten Ableitverbindung auf der zweiten Leiterplatte angeordnet. Dabei wird der zweite Filter so ausgebildet, dass der zweite Filter der ersten galvanischen Verbindung nachgeschaltet wird. Zusätzlich wird in einem Verfahrensschritt S7 ein dritter Filter so ausgebildet, dass er mit einer dritten Ableitverbindung zu dem Gehäuse auf der zweiten Leiterplatte angeordnet und der zweiten galvanischen Verbindung vorgeschaltet wird. Das Ausführen der Verfahrensschritte S5 bis S7 gewährleistet die oben schon beschriebenen Vorteile.

Das hier beschriebene Herstellungsverfahren ist jedoch nicht auf eine Ausstattung der Elektronikvorrichtung mit lediglich drei derartigen Filtern beschränkt. Als Ergänzung zu dem hier wiedergegebenen Herstellungsverfahren können weitere Filter auf mindestens einer weiteren Leiterplatte entsprechend ausgebildet werden.

In einer Weiterbildung des beschriebenen Herstellungsverfahrens kann mindestens eine plattenförmige Abschirmeinheit in dem Gehäuse der Elektronikvorrichtung angeordnet werden, wobei die zumindest teilweise aus einem leitfähigen Material ausgebildeten Abschirmeinheit mit einer zugeordneten Ableitverbindung des benachbart angeordneten Filters und dem Gehäuse elektrisch verbunden wird.

Die Ausführbarkeit des hier beschriebenen Herstellungsverfahrens ist nicht auf eine zeitliche Reihenfolge der Verfahrensschritte S1 bis S7 entsprechend ihrer Nummerierung beschränkt.

## Patentansprüche

1. Elektronikvorrichtung (50) mit:
einem zumindest teilweise aus einem leitfähigen Material ausgebildeten Gehäuse (52), wobei der Innenraum des Gehäuses (52) in einen Hochvoltbereich (54) und mindestens einen Niedervoltbereich (56) unterteilt ist;
einer in dem Gehäuse (52) angeordneten Invertiereinrichtung (58);
einer in dem Gehäuse (52) angeordneten ersten Leiterplatte (66), welche über mindestens eine Leitung (72) mit der Invertiereinrichtung (58) elektrisch verbunden ist, wobei die erste Leiterplatte (66) so in dem Gehäuse (52) angeordnet ist, dass ein Grenzbereich (84) zwischen dem Hochvoltbereich (54) und dem Niedervoltbereich (56) die erste Leiterplatte (66) schneidet;
einer in dem Gehäuse (52) in dem Niedervoltbereich (56) angeordneten zweiten Leiterplatte (68), welche über eine erste galvanische Verbindung (74) mit der ersten Leiterplatte (66) elektrisch verbunden ist und über eine zweite galvanische Verbindung (76) mit mindestens einer in dem Gehäuse (52) und/oder an dem Gehäuse (52) angeordneten Komponente (70) der Elektronikvorrichtung (50) elektrisch verbunden ist;
einem ersten Filter (86) mit einer ersten Ableitverbindung zu dem Gehäuse (52), welcher auf der ersten Leiterplatte (66) angeordnet und der ersten galvanischen Verbindung (74) vorgeschaltet ist;
einem zweiten Filter (88) mit einer zweiten Ableitverbindung zu dem Gehäuse (52), welcher auf der zweiten Leiterplatte (68) angeordnet und der ersten galvanischen Verbindung (74) nachgeschaltet ist; und einem dritten Filter (90) mit einer dritten Ableitverbindung zu dem Gehäuse (52), welcher auf der zweiten Leiterplatte (68) angeordnet und der zweiten galvanischen Verbindung (76) vorgeschaltet ist,
wobei der erste Filter (86), die erste galvanische Verbindung (74) und der zweite Filter (88) als ein erster Pi-Filter zusammenwirken..

2. Elektronikvorrichtung (50) nach Anspruch 1, wobei die zweite Leiterplatte (68) über die zweite galvanische Verbindung (76) mit einer dritten Leiterplatte (70) als der mindestens einen in dem Gehäuse (52) angeordneten Komponente (70) elektrisch verbunden ist, wobei die dritte Leiterplatte (70) über eine dritte galvanische Verbindung (78) mit mindestens einer in dem Gehäuse (52) und/oder an dem Gehäuse (52) angeordneten weiteren Komponente (80) der Elektronikvorrichtung (50) elektrisch verbunden ist, und wobei die Elektronikvorrichtung (50) einen vierten Filter (92) mit einer vierten Ableitverbindung zu dem Gehäuse (52), welcher auf der dritten Leiterplatte (70) angeordnet und der zweiten galvanischen Verbindung (76) nachgeschaltet ist, und einen fünften Filter (94) mit einer fünften Ableitverbindung zu dem Gehäuse (52), welcher auf der dritten Leiterplatte (70) angeordnet und der dritten galvanischen Verbindung (78) vorgeschaltet ist, umfasst.

3. Elektronikvorrichtung (50) nach Anspruch 1 oder 2, wobei der erste Filter (86), der zweite Filter (88), der dritte Filter (90), der vierte Filter (92) und/oder der fünfte Filter (94) als T-Filter ausgebildet sind.

4. Elektronikvorrichtung (50) nach einem der vorhergehenden Ansprüche, wobei die erste galvanische Verbindung (74) ein erstes Flachbandkabel, die zweite galvanische Verbindung (76) ein zweites Flachbandkabel und/oder die dritte galvanische Verbindung (78) ein drittes Flachbandkabel umfassen.

5. Elektronikvorrichtung (50) nach Anspruch 4, wobei das erste Flachbandkabel, das zweite Flachbandkabel und/oder das dritte Flachbandkabel eine Länge in einem Bereich zwischen 5 cm bis 50 cm und/oder eine Breite in einem Bereich zwischen 3 cm bis 12 cm haben.

6. Elektronikvorrichtung (50) nach Anspruch 2, wobei der dritte Filter (90), die zweite galvanische Verbindung (76) und der vierte Filter (92) als ein zweiter Pi-Filter zusammenwirken.

7. Elektronikvorrichtung (50) nach einem der vorhergehenden Ansprüche, wobei die Elektronikvorrichtung (50) mindestens eine plattenförmige Abschirmeinheit (96,98), welche zumindest teilweise aus einem leitfähigen Material ausgebildet und mit der zugeordneten Ableitverbindung des ersten, zweiten, dritten, vierten und/oder fünften Filters (86 bis 94) und dem Gehäuse (52) elektrisch verbunden ist, umfasst.

8. Elektronikvorrichtung (50) nach einem der vorhergehenden Ansprüche, wobei auf der ersten Leiterplatte (66) eine Invertersteuerung, auf der zweiten Leiterplatte (68) eine Steuerelektronik und/oder auf der dritten Leiterplatte (70) eine Steckerelektronik ausgebildet sind.

9. Elektronikvorrichtung (50) nach einem der vorhergehenden Ansprüche, wobei die Elektronikvorrichtung (50) als Leistungselektronik, als Pulswechselrichter, als Hybridmotor und/oder als DC/DC-Wandler ausgebildet ist.

10. Herstellungsverfahren für eine Elektronikvorrichtung (50) mit den Schritten:
Anordnen einer Invertiereinrichtung (58), einer ersten Leiterplatte (66) und einer zweiten Leiterplatte (68) in einem zumindest teilweise aus einem leitfähigen Material ausgebildeten Gehäuse (52) (S1), wobei der Innenraum des Gehäuses (52) in einen Hochvoltbereich (54) und mindestens einen Niedervoltbereich (56) unterteilt ist, wobei die erste Leiterplatte (66) so in dem Gehäuse (52) angeordnet ist, dass ein Grenzbereich (84) zwischen dem Hochvoltbereich (54) und dem Niedervoltbereich (56) die erste Leiterplatte /66) schneidet;
elektrisches Verbinden der Invertiereinrichtung (58) über mindestens eine Leitung (72) mit der ersten Leiterplatte (66) (S2);
elektrisches Verbinden der ersten Leiterplatte (66) über eine erste galvanische Verbindung (74) mit der in dem Niedervoltbereich (56) angeordneten zweiten Leiterplatte (68) (S3);
elektrisches Verbinden der zweiten Leiterplatte (68) über eine zweite galvanische Verbindung (76) mit mindestens einer in dem Gehäuse (52) und/oder an dem Gehäuse (52) angeordneten Komponente (70) der Elektronikvorrichtung (50) (S4);
Ausbilden eines auf der ersten Leiterplatte (66) angeordneten ersten Filters (86) mit einer ersten Ableitverbindung zu dem Gehäuse (52), wobei der erste Filter (86) der ersten galvanischen Verbindung (74) vorgeschaltet wird (S5);
Ausbilden eines auf der zweiten Leiterplatte (68) angeordneten zweiten Filters (88) mit einer zweiten Ableitverbindung zu dem Gehäuse (52), wobei der zweite Filter (88) der ersten galvanischen Verbindung (74) nachgeschaltet wird (S6); und
Ausbilden eines auf der zweiten Leiterplatte (68) angeordneten dritten Filters (90) mit einer dritten Ableitverbindung zu dem Gehäuse (52), wobei der dritte Filter (90) der zweiten galvanischen Verbindung (76) vorgeschaltet wird (S7),
wobei der erste Filter (86), die erste galvanische Verbindung (74) und der zweite Filter (88) als ein erster Pi-Filter zusammenwirken.

## Claims

1. Electronic apparatus (50) having:
a housing (52) which is at least partially formed from a conductive material, wherein the interior of the housing (52) is subdivided into a high-voltage region (54) and at least one low-voltage region (56);
an inverting device (58) which is arranged in the housing (52);
a first printed circuit board (66) which is arranged in the housing (52) and is electrically connected to the inverting device (58) via at least one line (72), wherein the first printed circuit board (66) is arranged in the housing (52) in such a manner that a border region (84) between the high-voltage region (54) and the low-voltage region (56) intersects the first printed circuit board (66);
a second printed circuit board (68) which is arranged in the housing (52) in the low-voltage region (56), is electrically connected to the first printed circuit board (66) via a first electrical connection (74) and is electrically connected to at least one component (70) of the electronic apparatus (50) arranged in the housing (52) and/or on the housing (52) via a second electrical connection (76);
a first filter (86) having a first discharge connection to the housing (52), which first filter is arranged on the first printed circuit board (66) and is connected upstream of the first electrical connection (74);
a second filter (88) having a second discharge connection to the housing (52), which second filter is arranged on the second printed circuit board (68) and is connected downstream of the first electrical connection (74); and
a third filter (90) having a third discharge connection to the housing (52), which third filter is arranged on the second printed circuit board (68) and is connected upstream of the second electrical connection (76),
wherein the first filter (86), the first electrical connection (74) and the second filter (88) interact as a first Pi filter.

2. Electronic apparatus (50) according to Claim 1, wherein the second printed circuit board (68) is electrically connected to a third printed circuit board (70), as the at least one component (70) arranged in the housing (52), via the second electrical connection (76), wherein the third printed circuit board (70) is electrically connected to at least one further component (80) of the electronic apparatus (50) arranged in the housing (52) and/or on the housing (52) via a third electrical connection (78), and wherein the electronic apparatus (50) comprises a fourth filter (92) having a fourth discharge connection to the housing (52), which fourth filter is arranged on the third printed circuit board (70) and is connected downstream of the second electrical connection (76), and a fifth filter (94) having a fifth discharge connection to the housing (52), which fifth filter is arranged on the third printed circuit board (70) and is connected upstream of the third electrical connection (78).

3. Electronic apparatus (50) according to Claim 1 or 2, wherein the first filter (86), the second filter (88), the third filter (90), the fourth filter (92) and/or the fifth filter (94) is/are in the form of a T filter.

4. Electronic apparatus (50) according to one of the preceding claims, wherein the first electrical connection (74) comprises a first ribbon cable, the second electrical connection (76) comprises a second ribbon cable and/or the third electrical connection (78) comprises a third ribbon cable.

5. Electronic apparatus (50) according to Claim 4, wherein the first ribbon cable, the second ribbon cable and/or the third ribbon cable has/have a length in a range between 5 cm and 50 cm and/or a width in a range between 3 cm and 12 cm.

6. Electronic apparatus (50) according to Claim 2, wherein the third filter (90), the second electrical connection (76) and the fourth filter (92) interact as a second Pi filter.

7. Electronic apparatus (50) according to one of the preceding claims, wherein the electronic apparatus (50) comprises at least one plate-shaped screening unit (96, 98) which is at least partially formed from a conductive material and is electrically connected to the associated discharge connection of the first, second, third, fourth and/or fifth filter (86 to 94) and to the housing (52).

8. Electronic apparatus (50) according to one of the preceding claims, wherein an inverter controller is formed on the first printed circuit board (66), control electronics are formed on the second printed circuit board (68) and/or plug electronics are formed on the third printed circuit board (70).

9. Electronic apparatus (50) according to one of the preceding claims, wherein the electronic apparatus (50) is in the form of power electronics, a pulse inverter, a hybrid motor and/or a DC/DC converter.

10. Production method for an electronic apparatus (50), having the steps of:
arranging an inverting device (58), a first printed circuit board (66) and a second printed circuit board (68) in a housing (52) at least partially formed from a conductive material (S1), wherein the interior of the housing (52) is subdivided into a high-voltage region (54) and at least one low-voltage region (56), wherein the first printed circuit board (66) is arranged in the housing (52) in such a manner that a border region (84) between the high-voltage region (54) and the low-voltage region (56) intersects the first printed circuit board (66);
electrically connecting the inverting device (58) to the first printed circuit board (66) via at least one line (72) (S2);
electrically connecting the first printed circuit board (66) to the second printed circuit board (68) arranged in the low-voltage region (56) via a first electrical connection (74) (S3);
electrically connecting the second printed circuit board (68) to at least one component (70) of the electronic apparatus (50) arranged in the housing (52) and/or on the housing (52) via a second electrical connection (76) (S4);
forming a first filter (86) which is arranged on the first printed circuit board (66) and has a first discharge connection to the housing (52), wherein the first filter (86) is connected upstream of the first electrical connection (74) (S5);
forming a second filter (88) which is arranged on the second printed circuit board (68) and has a second discharge connection to the housing (52), wherein the second filter (88) is connected downstream of the first electrical connection (74) (S6); and
forming a third filter (90) which is arranged on the second printed circuit board (68) and has a third discharge connection to the housing (52), wherein the third filter (90) is connected upstream of the second electrical connection (76) (S7),
wherein the first filter (86), the first electrical connection (74) and the second filter (88) interact as a first Pi filter.

## Revendications

1. Arrangement électronique (50) comprenant :
un boîtier (52) au moins partiellement constitué d'un matériau conducteur, l'espace intérieur du boîtier (52) étant subdivisé en une zone de haute tension (54) et au moins une zone de basse tension (56) ;
un dispositif onduleur (58) disposé dans le boîtier (52) ; un premier circuit imprimé (66) disposé dans le boîtier (52), lequel est relié électriquement au dispositif onduleur (58) par le biais d'au moins une ligne (72), le premier circuit imprimé (66) étant disposé dans le boîtier (52) de telle sorte qu'une zone de délimitation (84) entre la zone de haute tension (54) et la zone de basse tension (56) croise le premier circuit imprimé (66) ;
un deuxième circuit imprimé (68) disposé dans le boîtier (52) dans la zone de basse tension (56), lequel est relié électriquement au premier circuit imprimé (66) par le biais d'une première liaison galvanique (74) et relié électriquement à au moins un composant (70) de l'arrangement électronique (50) disposé dans le boîtier (52) et/ou sur le boîtier (52) par le biais d'une deuxième liaison galvanique (76) ;
un premier filtre (86) pourvu d'une première liaison de dérivation vers le boîtier (52), lequel est disposé sur le premier circuit imprimé (66) et branché en amont de la première liaison galvanique (74) ;
un deuxième filtre (88) pourvu d'une deuxième liaison de dérivation vers le boîtier (52), lequel est disposé sur le deuxième circuit imprimé (68) et branché en aval de la première liaison galvanique (74) ; et
un troisième filtre (90) pourvu d'une troisième liaison de dérivation vers le boîtier (52), lequel est disposé sur le deuxième circuit imprimé (68) et branché en amont de la deuxième liaison galvanique (76),
le premier filtre (86), la première liaison galvanique (74) et le deuxième filtre (88) coopérant sous la forme d'un premier filtre en Pi.

2. Arrangement électronique (50) selon la revendication 1, le deuxième circuit imprimé (68) étant relié électriquement par le biais de la deuxième liaison galvanique (76) à un troisième imprimé (70) en tant qu'au moins un composant (70) disposé dans le boîtier (52), le troisième imprimé (70) étant relié électriquement à au moins un composant supplémentaire (80) de l'arrangement électronique (50) disposé dans le boîtier (52) et/ou sur le boîtier (52) par le biais d'une troisième liaison galvanique (78), et l'arrangement électronique (50) comportant un quatrième filtre (92) pourvu d'une quatrième liaison de dérivation vers le boîtier (52), lequel est disposé sur le troisième circuit imprimé (70) et branché en aval de la deuxième liaison galvanique (76), et un cinquième filtre (94) pourvu d'une cinquième liaison de dérivation vers le boîtier (52), lequel est disposé sur le troisième circuit imprimé (70) et branché en amont de la troisième liaison galvanique (78).

3. Arrangement électronique (50) selon la revendication 1 ou 2, le premier filtre (86), le deuxième filtre (88), le troisième filtre (90), le quatrième filtre (92) et/ou le cinquième filtre (94) étant réalisés sous la forme de filtres en T.

4. Arrangement électronique (50) selon l'une des revendications précédentes, la première liaison galvanique (74) comportant un premier câble en nappe, la deuxième liaison galvanique (76) un deuxième câble en nappe et/ou la troisième liaison galvanique (78) un troisième câble en nappe.

5. Arrangement électronique (50) selon la revendication 4, le premier câble en nappe, deuxième câble en nappe et/ou le troisième câble en nappe ayant une longueur dans une plage entre 5 cm et 50 cm et/ou une largeur dans une plage entre 3 cm et 12 cm.

6. Arrangement électronique (50) selon la revendication 2, le troisième filtre (90), la deuxième liaison galvanique (76) et le quatrième filtre (92) coopérant sous la forme d'un deuxième filtre en Pi.

7. Arrangement électronique (50) selon l'une des revendications précédentes, l'arrangement électronique (50) comportant au moins une unité de blindage (96, 98) en forme de plaque, qui est au moins partiellement constituée d'un matériau conducteur et qui est reliée électriquement à la liaison de dérivation associée du premier, deuxième, troisième, quatrième et/ou cinquième filtre (86 à 94) et le boîtier (52).

8. Arrangement électronique (50) selon l'une des revendications précédentes, une commande d'onduleur étant configurée sur le premier circuit imprimé (66), une électronique de commande sur le deuxième circuit imprimé (68) et/ou une électronique de fiche sur le troisième circuit imprimé (70).

9. Arrangement électronique (50) selon l'une des revendications précédentes, l'arrangement électronique (50) étant réalisé sous la forme d'une électronique de puissance, d'un onduleur à impulsions, d'un moteur hybride et/ou d'un convertisseur CC/CC.

10. Procédé de fabrication pour un arrangement électronique (50), comprenant les étapes suivantes :
disposition d'un dispositif onduleur (58), d'un premier circuit imprimé (66) et d'un deuxième circuit imprimé (68) dans un boîtier (52) au moins partiellement constitué d'un matériau conducteur (S1), l'espace intérieur du boîtier (52) étant subdivisé en une zone de haute tension (54) et au moins une zone de basse tension (56), le premier circuit imprimé (66) étant disposé dans le boîtier (52) de telle sorte qu'une zone de délimitation (84) entre la zone de haute tension (54) et la zone de basse tension (56) croise le premier circuit imprimé (66) ;
connexion électrique du dispositif onduleur (58) au premier circuit imprimé (66) par le biais d'au moins une ligne (72) (S2) ;
connexion électrique du premier circuit imprimé (66) par le biais d'une première liaison galvanique (74) au deuxième circuit imprimé (68) disposé dans la zone de basse tension (56) (S3) ;
connexion électrique du deuxième circuit imprimé (68) par le biais d'une deuxième liaison galvanique (76) à au moins un composant (70) de l'arrangement électronique (50) disposé dans le boîtier (52) et/ou sur le boîtier (52) (S4) ;
formation d'un premier filtre (86) disposé sur le premier circuit imprimé (66), comprenant une première liaison de dérivation vers le boîtier (52), premier filtre (86) étant branché en amont de la première liaison galvanique (74) (S5) ;
formation d'un deuxième filtre (88) disposé sur le deuxième circuit imprimé (68), comprenant une deuxième liaison de dérivation vers le boîtier (52), le deuxième filtre (88) étant et branché en aval de la première liaison galvanique (74) (S6) ; et
formation d'un troisième filtre (90) disposé sur le deuxième circuit imprimé (68), comprenant une troisième liaison de dérivation vers le boîtier (52), le troisième filtre (90) étant branché en amont de la deuxième liaison galvanique (76) (S7),
le premier filtre (86), la première liaison galvanique (74) et le deuxième filtre (88) coopérant sous la forme d'un premier filtre en Pi.
